# EUROPÄISCHE PATENTSCHRIFT

(11) **EP 1 378 014 B1**
(45) Veröffentlichungstag und Bekanntmachung des Hinweises auf die Patenterteilung: **13.02.2008**
(21) Anmeldenummer: 02727597.3
(22) Anmeldetag: 14.05.2002
(51) Int. Cl.: H01L 41/047

(54) **ELEKTROMECHANISCHER WANDLER MIT MINDESTENS EINEM PIEZOELEKTRISCHEN ELEMENT**
ELECTROMECHANICAL CONVERTER COMPRISING AT LEAST ONE PIEZOELECTRIC ELEMENT
CONVERTISSEUR ELECTROMECANIQUE COMPRENANT AU MOINS UN ELEMENT PIEZO-ELECTRIQUE

(30) Priorität: 01.06.2001 DE 10126656
(43) Veröffentlichungstag der Anmeldung: 07.01.2004
(73) Patentinhaber: Endress + Hauser GmbH + Co. KG, 79689 Maulburg (DE)
(72) Erfinder: LOPATIN, Sergej, 79540 Lörrach (DE); BIRGEL, Dietmar, 79650 Schopfheim (DE); HAUPTVOGEL, Karl-Peter, F-68870 Bartenheim (FR)
(74) Vertreter: Andres, Angelika Maria
(86) Internationale Anmeldenummer: PCT/EP2002/005277
(87) Internationale Veröffentlichungsnummer: WO 2002/099904

(56) Entgegenhaltungen:
- DE-A- 10 028 319
- DE-A- 19 725 717
- JP-A- 11 004 027
- US-A- 4 417 170
- PATENT ABSTRACTS OF JAPAN vol. 009, no. 185 (E-332), 31. Juli 1985 (1985-07-31) & JP 60 054486 A (TOSHIBA CORP), 28. März 1985 (1985-03-28) -& JP 60 054486 A (TOSHIBA CORP) 28. März 1985 (1985-03-28)

## Beschreibung

Die Erfindung betrifft einen elektromechanischen Wandler mit mindestens einem piezoelektrischen Element.

Es gibt heute eine Vielzahl von Geräten, insb. Meßgeräten und Sensoren, bei denen piezoelektrische Elemente als elektromechanische Wandler eingesetzt werden.

Es sind z.B. Füllstandsgrenzschalter im Handel erhältlich, die zur Grenzstanddetektion, als Überfüllsicherung oder als Pumpenleerlaufschutz verwendet werden. Diese weisen z.B. ein in einen Behälter ragendes mechanisches Schwingungsgebilde auf, das mittels eines piezoelektrischen Elements oder mittels mehrer in einem Stapel angeordneter piezoelektrischer Elemente in Schwingungen versetzt wird. Es wird die Resonanzfrequenz und/oder die Amplitude einer angeregten Schwingung aufgenommen und daraus ermittelt, ob das Schwingungsgebilde frei schwingt oder von einem Füllgut bedeckt ist.

Die piezoelektrischen Elemente sind üblicherweise mit Elektroden versehen und werden mittels elektrischer Kontaktfahnen angeschlossen. Die Kontaktfahnen sind über elektrische Anschlußleitungen mit einer elektronischen Schaltung verbunden, über die die piezoelektrischen Elemente entweder zu Schwingungen angeregt werden, oder deren schwingungs-abhängige Signale abgenommen werden.

Beispiele für elektromechanische Wandler mit einem oder mehreren piezoelektrischen Elementen sind in der EP-A 875 742, der EP-A 875 741, der EP-A 875 740, EP-A 875 739 und der am 7. Juni 2000 eingereichten Europäischen Patentanmeldung 10028319.5 beschrieben.

Derzeit werden die Kontaktfahnen auf die Elektroden aufgeklebt. Es werden regelmäßig Kleber verwendet, die auf eine plane Oberfläche der Kontaktflächen der Elektroden bzw. der Kontaktfahnen aufgebracht werden. Die Dicke der Kleberschicht hängt dabei von der aufgebrachten Klebermenge, dem Anpreßdruck mit dem die zu verklebenden Teile aufeinander gebracht werden und der zum Teil sogar temperatur-abhängigen Viskosität des Klebers vor dem Aushärten ab. Es besteht ein Spalt zwischen der Elektrode und der Kontaktfahne. Ein solcher Spalt besteht natürlich auch, wenn die Kontaktfahne mit Lotpunkten versehen wird und auf die Elektrode aufgelötet wird.

Es treten bei dem Kleber mit der Zeit Setzeffekte ein, die sich auf die Kontaktsicherheit der Verbindung auswirken können.

Es ist eine Aufgabe der Erfindung, einen elektromechanischen Wandler mit mindestens einem piezoelektrischen Element anzugeben, bei dem ein elektrischer Anschluß des piezoelektrischen Elements mit einer sehr hohen Kontaktsicherheit vorliegt.

Patent Abstracts of Japan, vol.009, no.185 (8-332) and JP-A-60054486 offenbaren einen elektromechanischen Wandler gemäß dem Oberbegriff von Anspruch 1.

Hierzu besteht die Erfindung gemäß Anspruch 1 in einem elektromechanischen Wandler mit
- mindestens einem piezoelektrischen Element mit einer ersten Oberfläche auf die eine erste Elektrode aufgebracht ist, und
- mindestens einer Kontaktfahne,
   -- über die das piezoelektrische Element elektrisch angeschlossen ist,
   -- die unmittelbar an der ersten Elektrode anliegt, und
   -- die mindestens eine Ausnehmung aufweist,
   -- in die ein Kleber eingebracht ist, durch den die Kontaktfahne mit der Elektrode verbunden ist.

Gemäß einer Ausgestaltung ist der Kleber elektrisch leitfähig.

Gemäß einer Ausgestaltung ist der Kleber ein Kleber, der zur Befestigung von SMD-Bauteilen verwendbar ist.

Gemäß einer Ausgestaltung ist die Ausnehmung in die Kontaktfahne eingeätzt.

Gemäß einer Ausgestaltung weist das piezoelektrische Element auf der ersten Oberfläche mindestens eine weitere Elektrode auf, und für jede Elektrode ist eine Kontaktfahne vorgesehen, über die die jeweilige Elektrode elektrisch angeschlossen ist.

Gemäß einer Ausgestaltung sind die Kontaktfahnen aus einer Leiterplatte herausgeführte Anschlußfahnen, die in der Leiterplatte in in der Leiterplatte verlaufende Leiterbahnen übergehen.

Gemäß einer Ausgestaltung ist die Leiterplatte eine flexible Leiterplatte, die mehrere Kontaktfahnen aufweist,
wobei auf jeder Kontaktfahne ein piezoelektrisches Element angeordnet ist, und die piezoelektrischen Elemente in einem Stapel angeordnet sind.

Weiter besteht die Erfindung gemäß Anspruch 8 in einem Verfahren zur Herstellung eines vorgenannten elektromechanischen Wandlers, bei dem die Ausnehmungen in die Kontaktfahnen eingeätzt werden, Kleber in die Ausnehmungen eingebracht wird, und die piezoelektrischen Elemente maschinell auf die Kontaktfahen aufgesetzt werden.

Die Erfindung und weitere Vorteile werden nun anhand der Figuren der Zeichnung, in denen drei Ausführungsbeispiele dargestellt sind, näher erläutert; gleiche Elemente sind in den Figuren mit gleichen Bezugszeichen versehen.
- Fig. 1: zeigt schematisch ein piezoelektrisches Element mit einer damit verbundenen Kontaktfahne; -
- Fig. 2: zeigt eine Draufsicht auf eine dem piezoelektrischen Element zugewandte Seite der Kontaktfahne;
- Fig. 3: zeigt eine Ansicht eines piezoelektrischen Elements bei dem auf einer ersten Oberfläche zwei Elektroden angeordnet sind;
- Fig. 4: zeigt eine flexible Leiterplatte, die zwei Kontaktfahnen aufweist;
- Fig. 5: zeigt eine flexible Leiterplatte mit sechs Kontaktfahnen; und
- Fig. 6: zeigt in einem Stapel angeordnete an Kontaktfahnen angeschlossene piezoelektrische Elemente.

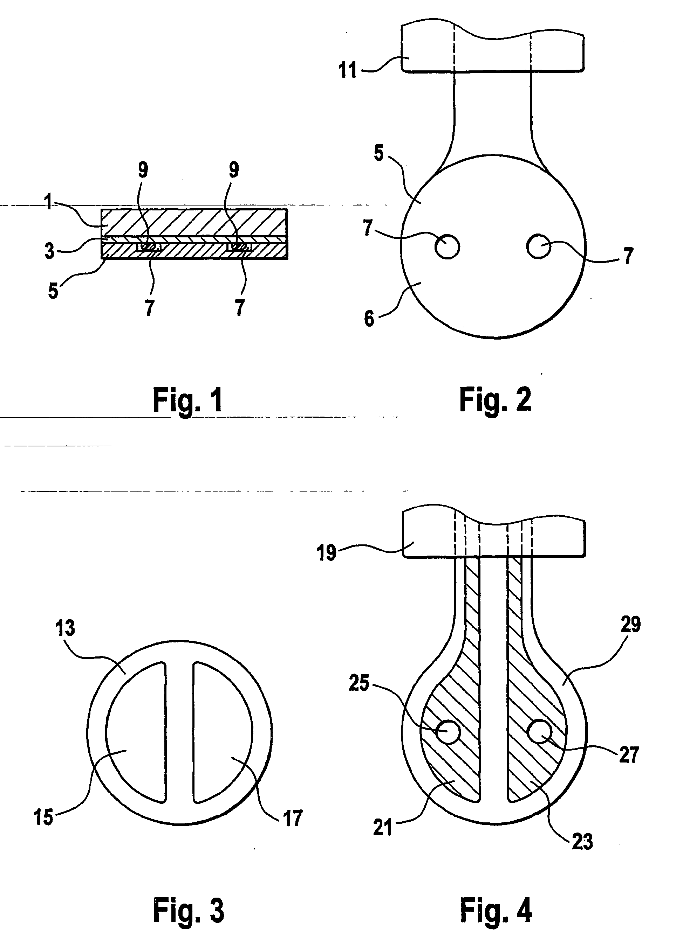

Fig. 1 zeigt schematisch einen elektromechanischen Wandler. Der Wandler weist ein piezoelektrisches Element 1 auf.
Das piezoelektrische Element 1 ist in dem dargestellten Ausführungsbeispiel kreisscheibenförmig und weist eine erste Oberfläche auf, auf der eine erste Elektrode 3 aufgebracht ist. Die erste Elektrode 3 ist z.B. eine dünne Silberschicht, die auf das piezeoelektrische Element 1 aufgebracht, z.B. aufgesputtert ist.

Es ist eine Kontaktfahne 5 vorgesehen, über die das piezoelektrische 1 Element elektrisch angeschlossen ist.
Fig. 2 zeigt eine Draufsicht auf eine dem piezoelektrischen Element 1 zugewandte Seite der Kontaktfahne 5.

Die Kontaktfahne 5 weist einen kreisscheibenförmigen Abschnitt 6 auf, mit dem sie flächig unmittelbar an der ersten Elektrode 3 anliegt. Die Kontaktfahne 5 weist mindestens eine Ausnehmung 7 auf, in die jeweils ein Kleber 9 eingebracht ist. In dem in Fig. 1 dargestellten Ausführungsbeispiel sind zwei Ausnehmungen vorgesehen. Durch den Kleber 9 ist die Kontaktfahne 5 mit der Elektrode 3 verbunden.

Als Kleber 9 ist z.B. ein elektrisch leitfähiger Kleber, oder ein Kleber, wie er zur Befestigung von SMD-Bauteilen verwendet wird, besonders geeignet.

Die Kontaktfahne 5 ist in dem dargestellten Ausführungsbeispiel integraler Bestandteil einer flexible Leiterplatte 11. Flexible Leiterplatter werden z.B. von der Firma Schoeller Elektronik unter dem Handelsnamen Polyflex vertrieben. Sie bestehen z.B. aus einem dünnen Kupferblech, das von der Firma Schoeller Elektronik entsprechend einer gewünschten Leiterbahnkonfiguration in einem Ätzprozeß behandelt und auf das nachfolgend beidseitig jeweils eine dicke Polyimid-Deckfolie auflaminiert wird.

Bei dem in Fig. 2 dargestellten Ausführungsbeispiel ist eine flexible Leiterplatte 11 verwendet, bei der die Kontaktelektrode 5 eine aus der flexiblen Leiterplatte 11 heraus geführte flächige Anschlußfahnen ist. Die Anschlußfahnen sind integraler Bestandteil der flexiblen Leiterplatte 11. Sie wird z.B. aus entsprechend geformten Segmenten des Kupferblechs gebildet, die nicht mit einer Deckfolie versehen sind. Die Ausnehmungen 7 werden vorzugsweise in die Kontaktfahnen 5 eingeätzt. Die Ausnehmungen weisen z.B. eine Tiefe von 3 µm auf.

Vorzugsweise werden große Mengen an flexiblen Leiterplatten gleichzeitig maschinell bearbeitet, indem mittels einer Ätzmaske alle auf allen Leiterplatten einer Charge vorgesehenen Ausnehmungen 7 eingeätzt werden. Anschließend wird der Kleber 9 maschinell mittels eines Dispensers oder im Siebdruckverfahren aufgebracht und in einem letzten Arbeitsschritt werden die piezoelektrischen Elemente 1 aufgesetzt und angepreßt. Wird ein Kleber 9 verwendet, der beim Aushärten schrumpft, so werden die beiden Bauteile zusätzlich durch den Kleber 9 aufeinander zu bewegt.

Da der Kleber 9 vollständig in den Ausnehmungen 7 verbleibt, besteht eine quasi spaltfreie elektrische Ankopplung der Kontaktfahne 5 an die Elektrode 3. Der Abstand zwischen der Kontaktfahne 5 und der Elektrode 3 wird im wesentlichen durch Fertigungstoleronzen bei der Herstellung von Elektrode 3 und Kontaktfahne 5 bestimmt und liegt deutlich unterhalb von 10 µm. Bei diesen geringen Abständen besteht hinsichtlich der Qualität der elektrischen Anbindung kein Unterschied mehr zwischen einer kapazitiven und einer konduktiven Anbindung.

Anstelle einer einzigen auf dem piezoelektrischen Element angeordneten Elektrode, können selbstverständlich auch zwei oder mehr Elektroden vorgesehen sein, die auf die zuvor beschriebene Weise jeweils an eine der jeweiligen Elektrode zugeordnete Kontaktfahne angeschlossen sind.

Fig. 3 zeigt eine Ansicht einer ersten Oberfläche eines piezoelektrischen Element 13, bei dem auf der ersten Oberfläche zwei Elektroden 15, 17 angeordnet sind. Die Elektroden 15, 17 sind halbkreisförmig und können z.B. dazu dienen die beiden Hälften eines kreisscheibenförmigen homogen polarisierten piezoelektrischen Elements zu gegenphasigen Schwingungen anzuregen. Weitere Anwendungen für piezoelektrische Elemente mit mindestens zwei Elektroden sind z.B. in der EP-A 875 740 und in der EP-A 875 739 beschrieben.

Fig. 4 zeigt eine Ansicht einer in Verbindung mit dem in Fig. 3 dargestellten piezoelektrischen Element 13 verwendbare flexible Leiterplatte 19, die für jede Elektrode 15, 17 eine Kontaktfahne 21, 23 aufweist, über die die jeweilige Elektrode 15, 17 elektrisch angeschlossen ist. Bei dem in den Figuren 3 und 4 dargestellten Ausführungsbeispiel weist jede Kontaktfahne 21, 23 eine Ausnehmung 25, 27 auf, in die Kleber einzubringen ist. Die Verbindung und der elektrische Anschluß der Elektroden 15, 17 erfolgt analog zu der Verbindung und dem elektrischen Anschluß, wie er oben in Verbindung mit den Figuren 1 und 2 beschrieben ist.

Auch bei dem in Fig. 4 dargestellten Ausführungsbeispiel ist eine flexible Leiterplatte verwendet, bei der die Kontaktelektroden 21, 23 aus der flexiblen Leiterplatte 19 heraus geführte flächige Anschlußfahnen sind. Die Anschlußfahnen sind integraler Bestandteil der flexiblen Leiterplatte 19. Sie werden z.B. aus entsprechend geformten Segmenten des Kupferblechs gebildet. Die Segmente sind in diesem Ausführungsbeispiel nur auf der von dem piezoelektrischen Element 13 abgewandten Seite mit einer Deckfolie 29 versehen sind. Auf der dem piezoelektrischen Element 13 zugewandten Seite liegen die Kontaktfahnen 21, 23 frei. In der Leiterplatte 19 gehen die Kontaktfahnen 21, 23 in in der Leiterplatte 19 verlaufende Leiterbahnen über. Die Ausnehmungen 25, 27 sind auch hier in die Kontaktfahnen 21, 23 mit einer Tiefe von ca. 3 µm eingeätzt.

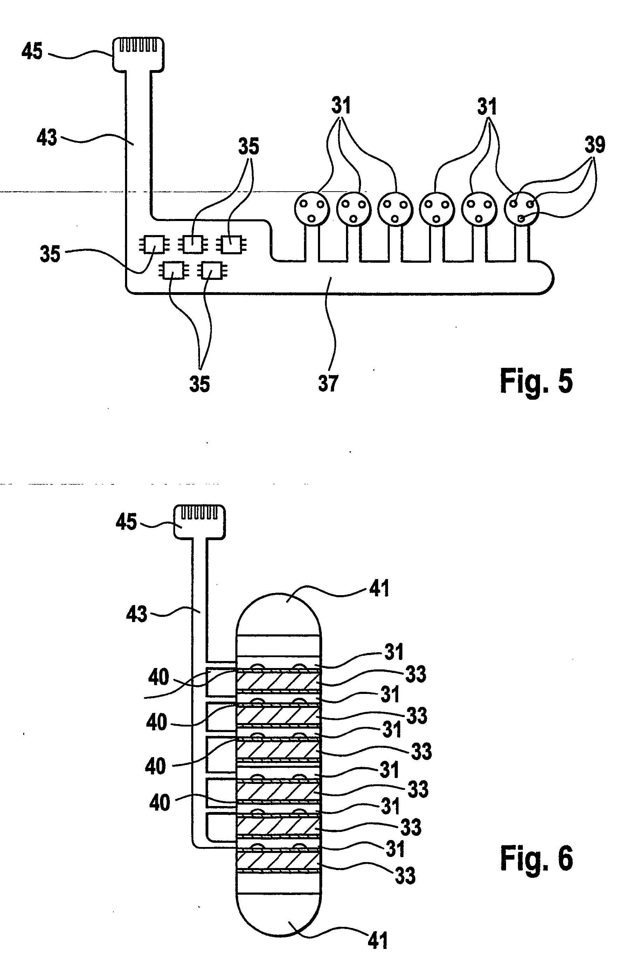

In den Figuren 5 und 6 ist ein weiteres Ausführungsbeispiel eines erfindungsgemäßen elektromechanischen Wandlers dargestellt. Fig. 5 zeigt eine Ansicht einer flexiblen Leiterplatte, die mehrere aus der flexiblen Leiterplatte, wie in Verbindung mit den vorigen Figuren beschrieben, herausgeführte Kontaktfahnen 31 aufweist. Fig. 6 zeigt die Leiterplatte von Fig. 5, wobei auf jeder Kontaktfahne 31 ein piezoelektrisches Element 33 angeordnet ist, und die piezoelektrischen Elemente 33 in einem Stapel angeordnet sind.

Die flexible Leiterplatte weist einen stufenförmig ausgebildeten Abschnitt 37 auf. Er umfaßt in dem gezeigten Ausführungsbeispiel sechs Stufen. An jeder Stufe ist eine flächige Anschlußfahne als Kontaktfahne 31 heraus geführt. Die Anschlußfahnen weisen jeweils einen schmalen Steg und eine an dessen stufenabgewandten Ende angeformte kreisscheibenförmige Elektrodenfläche auf. In jeder Elektrodenfläche sind drei Ausnehmungen 39 vorgesehen, in die analog zu den vorherigen Ausführungsbeispielen Kleber einzubringen ist.

Die Stufen weisen eine Höhe auf, die gleich der Dicke der an die jeweilige Stufen angrenzenden piezoelektrischen Elemente 33 ist.

Bei der Montage der piezoelektrischen Elemente 33 wird in die Ausnehmungen 39 ein Kleber, z.B. ein Leitkleber oder ein SMD-Kleber, eingebracht und es werden dann die piezoelektrischen Element 33 aufgesetzt. Dabei liegen die piezoelektrischen Elemente 33 jeweil mit einer in Fig. 6 schwarz schraffierten Elektrode 40 flächig auf der jeweils zugeordneten Kontaktfahne 31 auf.

Nachfolgend werden die Kontaktfahnen 31 durch Verformen der flexiblen Leiterplatte parallel zueinander und übereinander angeordnet. Bei dem hier dargestellten Ausführungsbeispiel erfolgt dies, indem alle Kontaktfahnen 31 aufgestellt werden, bis sie senkrecht zum Abschnitt 37 der Leiterplatte verlaufen, und der Abschnitt 37 beginnend von der Seite der niedrigsten Stufe her aufgerollt wird. Dadurch werden die piezoelektrischen Elemente 33 aufeinander gestapelt. Der so vorgeformte Stapel wird anschließend zwischen zwei halbkugelförmige Stempel 41 gesetzt und verpreßt, um eine sichere elektrische Verbindung zwischen den Kontaktfahnen 31 und den piezoelektrischen Elementen 33 zu gewährleisten.

Die hier dargestellte Form einer flexiblen Leiterplatte ist in der am 7. Juni 2000 eingereichten Europäischen Patentanmeldung 10028319.5 beschrieben. Dort sind auch weitere Varianten von in einem Stapel angeordneten piezoelektrischen Elementen angegeben, auf die die hier beschriebene Erfindung analog anwendbar ist.

Die Kontaktfahnen 31 gehen in in der Leiterplatte verlaufende Leiterbahnen über, über die die einzelnen piezoelektrischen Elemente 33 elektrisch ansprechbar sind.

Je nach Beschaltung können die einzelnen piezoelektrischen Elemente 33 elektrisch in Reihe oder parallel geschaltet sein. Es können auch mehrer piezoelektrische Elemente 33 zu einem Sender in Reihe und andere zu einem Empfänger in Reihe zusammen geschaltet sein.

Die Leiterplatte weist einen schmalen senkrecht zu dem Abschnitten 37 sich erstreckenden Fortsatz 43 auf, an dessen Ende ein Stecker 45 vorgesehen ist. In dem Fortsatz 43 sind sämtliche Leitungen der Leiterplatte fortgeführt, die mit einem Anschluß außerhalb der Leiterplatte zu verbinden sind.

Auf der Leiterplatte sind neben den piezoelektrischen Elementen 33 elektronische Bauteile, vorzugsweise SMD-Bauteile 35, angeordnet. Dies sind z.B. Strom und Spannung begrenzende Elemente oder aber auch Teile einer Signalaufnahme und/oder Signalverarbeitungsschaltung. SMD-Bauteile 35 können zusammen mit den piezoelektrischen Elementen 33 in einem Arbeitsgang aufgebracht werden.

Bei allen beschriebenen Ausführungsbeispielen werden in einem ersten Arbeitsschritt die Ausnehmungen 7, 25, 27, 39 in die Kontaktfahnen 5, 29, 31 eingeätzt. Anschließend wird der Kleber, vorzugsweise maschinell, z.B. mit einem Dispenser oder im Siebdruckverfahren in die Ausnehmungen 7, 25, 27, 39 eingebracht und es werden die piezoelektrischen Elemente 1, 13, 33 vorzugsweise maschinell auf die Kontaktfahnen 7, 25, 27, 39 aufgesetzt. Dabei werden die piezoelektrischen Elemente 1, 13, 33 vorzugsweise wie SMD-Bauteile behandelt und zusammen mit eventuell erforderlichen SMD-Bauteilen 35 mittels eines Bestückungsautomaten auf die Leiterplatten aufgebracht.

Durch die Einbringung des Klebers 9 in die Ausnehmungen 7, 25, 27, 39 ist eine sehr gute und gleichbleibende elektrische Ankopplung der piezoelektrischen Elemente 1, 13, 33 gewährleistet. Gleichzeitig ist ein voll automatisierbarer Herstellprozeß möglich.

## Patentansprüche

1. Elektromechanischer Wandler mit
- mindestens einem piezoelektrischen Element (1, 13, 33) mit einer ersten Oberfläche auf die eine erste Elektrode (3, 15, 17) aufgebracht ist, und
- mindestens einer Kontaktfahne (5, 29, 31)
-- über die das piezoelektrische Element (1, 13, 33) elektrisch angeschlossen ist,
-- die unmittelbar an der ersten Elektrode (3, 15, 17) anliegt, **dadurch gekennzeichnet daß** die Kontaktfahne mindestens eine Ausnehmung (7, 25, 27, 39) aufweist,
in die ein Kleber (9) eingebracht ist, durch den die Kontaktfahne (5, 29, 31) mit der Elektrode (3, 15, 17) verbunden ist.

2. Elektromechanischer Wandler nach Anspruch 1, bei dem der Kleber (9) elektrisch leitfähig ist.

3. Elektromechanischer Wandler nach Anspruch 1, bei dem der Kleber (9) ein Kleber ist, der zur Befestigung von SMD-Bauteilen verwendbar ist.

4. Elektromechanischer Wandler nach Anspruch 1, bei dem die Ausnehmung (7, 25, 27, 39) in die Kontaktfahne (5, 29, 31) eingeätzt ist.

5. Elektromechanischer Wandler nach Anspruch 1, bei dem
- das piezoelektrischen Element (13) auf der ersten Oberfläche mindestens eine weitere Elektrode (15, 17) aufweist, und
- für jede Elektrode (15, 17) eine Kontaktfahne (21, 23) vorgesehen ist,
-- über die die jeweilige Elektrode (15, 17) elektrisch angeschlossen ist.

6. Elektromechanischer Wandler nach Anspruch 1, bei dem die Kontaktfahnen (5, 21, 23) aus einer Leiterplatte (11, 19) herausgeführte Anschlußfahnen sind, die in der Leiterplatte (11, 19) in in der Leiterplatte (11, 19) verlaufende Leiterbahnen übergehen.

7. Elektromechanischer Wandler nach Anspruch 6, bei dem
- die Leiterplatte eine flexible Leiterplatte ist,
-- die mehrere Kontaktfahnen (31) aufweist, wobei
- auf jeder Kontaktfahne (31) ein piezoelektrisches Element (33) angeordnet ist, und
- die piezoelektrischen Elemente (33) in einem Stapel angeordnet sind.

8. Verfahren zur Herstellung eines elektromechanischen Wandlers nach Anspruch 1, bei dem
- die Ausnehmungen (9, 25, 27, 39) in die Kontaktfahnen (5, 29, 31) eingeätzt werden,
- Kleber (9) in die Ausnehmungen (9, 25, 27, 39) eingebracht wird, und
- die piezoelektrischen Elemente (1, 13, 33) maschinell auf die Kontaktfahnen (5, 21, 23, 31) aufgesetzt werden.

## Claims

1. An electromechanical transducer with
- at least one piezoelectric element (1, 13, 33) with a first surface to which a first electrode (3, 15, 17) is attached, and
- at least one contact tab (5, 29, 31)
- by way of which the piezoelectric element (1, 13, 33) is connected electrically,
- and which rests directly against the first electrode (3, 15, 17),
**characterized in that** the contact tab has at least one recess (7, 25, 27, 39) into which an adhesive (9) is introduced by which the contact tab (5, 29, 31) is joined to the electrode (3, 15, 17).

2. An electromechanical transducer according to Claim 1, in which the adhesive (9) is electrically conductive.

3. An electromechanical transducer according to Claim 1, in which the adhesive (9) is an adhesive which is capable of being used to fasten SMD components.

4. An electromechanical transducer according to Claim 1, in which the recess (7, 25, 27, 39) is etched into the contact tab (5, 29, 31).

5. An electromechanical transducer according to Claim 1, in which
- the piezoelectric element (13) on the first surface has at least one further electrode (15, 17), and
- a contact tab (21, 23) is provided for each electrode (15, 17),
- by way of which contact tab (21, 23) the respective electrode (15, 17) is connected electrically.

6. An electromechanical transducer according to Claim 1, in which the contact tabs (5, 21, 23) are attachment tabs which are formed out of a printed-circuit board (11, 19) and which in the printed-circuit board (11, 19) merge into conducting tracks extending in the printed-circuit board (11, 19).

7. An electromechanical transducer according to Claim 6, in which
- the printed-circuit board is a flexible printed-circuit board
- which comprises a plurality of contact tabs (31), wherein
- a piezoelectric element (33) is arranged on each contact tab (31), and
- the piezoelectric elements (33) are arranged in a stack.

8. A method of producing an electromechanical transducer according to Claim 1, in which
- the recesses (9, 25, 27, 39) are etched into the contact tabs (5, 29, 31),
- adhesive (9) is introduced into the recesses (9, 25, 27, 39), and
- the piezoelectric elements (1, 13, 33) are placed on the contact tabs (5, 21, 23, 31) mechanically.

## Revendications

1. Convertisseur électromécanique avec
- au moins un élément piézoélectrique (1, 13, 33) avec une première surface, sur laquelle est disposée une première électrode (3, 15, 17), et
- au moins une languette de contact (5, 29, 31)
-- par l'intermédiaire de laquelle l'élément piézoélectrique (1, 13, 33) est raccordé électriquement,
-- qui repose directement sur la première électrode (3, 15, 17),
**caractérisé en ce que** la languette de contact présente au moins un évidement (7, 25, 27, 39), à travers lequel est appliqué de la colle (9), au moyen de laquelle la languette de contact (5, 29, 31) est reliée avec l'électrode (3, 15, 17).

2. Convertisseur électromécanique selon la revendication 1, pour lequel la colle (9) est électroconductrice.

3. Convertisseur électromécanique selon la revendication 1, pour lequel la colle (9) est une colle pouvant être utilisée pour la fixation de composants CMS.

4. Convertisseur électromécanique selon la revendication 1, pour lequel l'évidement (7, 25, 27, 39) est gravé dans la languette de contact (5, 29, 31).

5. Convertisseur électromécanique selon la revendication 1, pour lequel
- l'élément piézoélectrique (13) comporte sur la première surface au moins une nouvelle électrode (15, 17), et
- est prévue pour chaque électrode (15, 17) une languette de contact (21, 23),
-- par l'intermédiaire de laquelle l'électrode (15, 17) respective est raccordée électriquement.

6. Convertisseur électromécanique selon la revendication 1, pour lequel les languettes de contact (5, 21, 23) sont des languettes de raccordement sorties d'un circuit imprimé (11, 19), languettes qui, sur le circuit imprimé (11, 19), sont reliées à des pistes tracées dans le circuit imprimé (11, 19).

7. Convertisseur électromécanique selon la revendication 6, pour lequel
- le circuit imprimé est un circuit imprimé flexible,
-- qui présente plusieurs languettes de contact (31),
- un élément piézoélectrique (33) étant disposé sur chaque languette de contact (31), et
- les éléments piézoélectriques (33) étant disposés sous forme de pile.

8. Procédé destiné à la fabrication d'un convertisseur électromécanique selon la revendication 1, pour lequel
- les évidements (9, 25, 27, 39) sont gravés dans les languettes de contact (5, 29, 31),
- de la colle (9) est appliquée dans les évidements (9, 25, 27, 39), et
- les éléments piézoélectriques (1, 13, 33) sont placés à la machine sur les languettes de contact (5, 21, 23, 31).
